# EUROPÄISCHE PATENTANMELDUNG

(11) **EP 1 199 915 A2**
(43) Veröffentlichungstag der Anmeldung: **24.04.2002**
(21) Anmeldenummer: 01124554.5
(22) Anmeldetag: 13.10.2001
(51) Int. Cl.: H05K 3/46, H05K 3/44

(54) **Schaltungsstrukturen auf thermisch gespritzten Schichten**

(30) Priorität: 21.10.2000 DE 10052247
(71) Anmelder: Hella KG Hueck & Co., 59552 Lippstadt (DE)
(72) Erfinder: Bolzenius, Rainer, 59581 Warstein (DE); Sellent, Manfred, 59557 Lippstadt (DE)

(57) **Zusammenfassung**

Die vorliegende Erfindung betrifft verschiedene Verfahren zur Herstellung einer elektrischen Schaltung auf einem Trägerkörper. Auf den Trägerkörper, etwa einen Metallkörper, wird eine erste, elektrisch isolierende Basisschicht durch thermisches Spritzen aufgebracht (220).

Danach wird in einem weiteren Schritt (230) eine zweite, beispielsweise elektrisch leitende Schicht auf die Basisschicht aufgebracht, die dann ihrerseits durch subtraktives Strukturieren (240) gemäß vorbestimmter Schaltstrukturen strukturiert wird. Dadurch, daß die angestrebte Schaltungsstruktur der zweiten Schicht aus dem Vollen abgetragen wird, kann je nach verwendeter Abtragungstechnik eine sehr hohe räumliche Auflösung dieser Strukturen erreicht werden. Ein weiterer Vorteil besteht darin, daß in Großserien fein strukturierte Schaltungen auf Trägerrohlingen wirtschaftlich erzeugbar sind, da kein nennenswerter Verschleiß an Masken stattfindet.

## Beschreibung

### STAND DER TECHNIK

Die vorliegende Erfindung betrifft Verfahren zur Herstellung einer elektrischen Schaltung auf einem Trägerkörper, insbesondere solche Verfahren, bei denen eine erste isolierende Basisschicht mit gemäß der Schaltung vorbestimmten, physikalischen Eigenschaften auf den Trägerkörper thermisch gespritzt wird.

Die eingangs genannten Schaltungen elektrischer, elektronischer und/ oder mechatronischer Art unterliegen der allgemein vorhandenen Miniaturisierungstendenz, immer mehr Schaltungselemente auf immer weniger Raum unterzubringen, und dabei je nach Einsatzgebiet besonders robuste Schaltkreise zu bilden.

Ein Verfahren zur Herstellung solcher miniaturisierungsfähiger, monolithischer, mehrschichtiger Schaltungseinrichtungen auf einem Trägerkörper ist in der europäischen Patentschrift EP 0 823 832 offenbart.

Dabei wird zunächst eine elektrisch isolierende Basisschicht auf einen Trägerkörper thermisch gespritzt. Damit die Größe und Dicke elektrisch leitender Strukturen in einem relativ einfachen Produktionsprozeß frei gewählt werden kann, um gegebenenfalls auch große Ströme in einer leitenden Schicht relativ verlustfrei leiten zu können, wird vorgeschlagen, für die verschiedenen Schichten des weiteren Schichtaufbaus das sogenannte 'thermische Spritzen' als Auftragetechnik zu verwenden.

Dabei wird zunächst also die eingangs erwähnte, isolierende Basisschicht auf ein Substratmaterial, beispielsweise ein Metallblech, das anfangs in geeigneter Weise aufgerauht wird, durch thermisches Spritzen aufgebracht.

Danach wird - ebenfalls durch thermisches Spritzen - eine elektrisch leitende Struktur mittels Maskierung 'additiv' aufgetragen.

Ein genereller Nachteil des dort offenbarten Verfahrens besteht darin, daß die durch Masken gespritzten Schaltungen zu aufwendig herstellbar sind.

Desweiteren ist der Aufbauträger nicht mit ausreichend feinen Strukturen herstellbar.

Nachteilig an diesem Herstellungsverfahren ist die mangelnde räumliche Auflösung der herzustellenden Schaltstrukturen, die mit der Verwendung der Spritzmasken einher geht. Die Spritzmasken bilden während des Spritzens Streuhindernisse, die eine gewisse unscharfe Schattenbildung durch Verwirbelung des Spritzmaterials auf die jeweilige Unterlage verursachen.

Des weiteren wird das dort vorgeschlagene Herstellungsverfahren auch dadurch in seiner Durchführung und seiner Wirtschaftlichkeit begrenzt, daß über die gesamte Spritzfläche hinweg ein vorbestimmter Spritzwinkel zwischen Spritzstrahl und Maske innerhalb geringer Toleranzgrenzen sowie ein genauer Abstand zwischen Substrat und Maske von beispielsweise etwa 0,1 mm eingehalten werden muß. Sobald sich letztgenannter Abstand um nur wenige Prozent verändert, ergeben sich erhebliche Abweichungen vom angestrebten Spritzmuster auf dem Substrat. So können beispielsweise leitende Kupferbahnen und zwischenliegende Abstände mit etwa 2 mm Breite hergestellt werden. Solche Abmessungen sind jedoch zu groß, um die mittlerweile erhöhten Anforderungen an die Miniaturisierung von elektrischen oder elektronischen Verdrahtungsträgern zu erfüllen.

Ein weiterer Nachteil des in der EP 823 832 offenbarten Herstellungsverfahrens besteht darin, daß die Spritzmasken vor einer erneuten Verwendung in kurzen Intervallen von den Resten des Spritzmaterials befreit werden müssen, oder, alternativ die Notwendigkeit besteht, immer wieder neue Spritzmasken verwenden zu müssen. Dies verteuert das Verfahren erheblich. Die Standzeit der Schablonen ist damit stark begrenzt.

Daher besteht die Aufgabe der vorliegenden Erfindung gemäß ihrem breitesten Aspekt darin, Verfahren zur Herstellung einer elektrischen Schaltung mit wenigstens einer thermisch gespritzten Schicht auf einem Trägerkörper zu schaffen, wobei das Problem unscharfer Schaltstrukturen vermieden werden soll.

### VORTEILE DER ERFINDUNG

Die erfindungsgemäßen Verfahren mit den Merkmalen der verfahrensbezogenen Nebenansprüche 1, 4 und 12 lösen die Aufgabe. In den Unteransprüchen finden sich vorteilhafte Weiterbildungen und Verbesserungen des jeweiligen Gegenstandes der Erfindung. Es wird daher nun auf die Ansprüche selbst Bezug genommen.

Unter 'elektrischen Schaltungen' werden im Sinne der vorliegenden Erfindungen auch Strukturen verstanden, die aufgrund der Gestaltung des Aufbauträgers selbst elektrische Funktionen aufweisen, beispielsweise Kapazitäten, Induktivitäten. Es soll jedoch verstanden werden, dass die erfindungsgemäßen Herstellungsverfahren ebenfalls die Herstellung von Trägerkörpern sowie elektronische oder mechatronische Schaltungen betreffen.

Es wird auf einen Trägerkörper, der zunächst aus einem beliebigen Material mit üblichen, mechanisch stabilen Eigenschaften bestehen kann, also etwa einem Metallkörper, Kunststoff-, Keramik-, Glaskörper, oder einem Verbundwerkstoff, oder Werkstoffverbunden eine erste Basisschicht durch thermisches Spritzen aufgebracht. Für dieses thermische Spritzen ist der Stand der Technik der Spritztechnologie etwa durch sogenanntes 'Plasmaspritzen in Kammern' gegeben, wie es beispielsweise durch die Fa. Sulzer Metco Switzerland AG durchgeführt wird. Dieser Spritzvorgang kann bei Bedarf auf Teilbereiche eines Substrats begrenzt werden. Auf ein Grundsubstrat wird also durch thermisches Spritzen eine isolierende Basisschicht ganzflächig flächenfüllend aufgetragen.

Der weitere Lagenaufbau ist summarisch der folgende:

Auf diese Basisschicht wird ebenfalls durch ganzflächiges, also die Fläche ausfüllendes, thermisches Spritzen eine zweite, jedoch elektrisch leitende Schicht aufgetragen.

Gemäß einem ersten, wesentlichen Aspekt der vorliegenden Erfindung wird diese zweite ganzflächig aufgetragene Schicht nun subtraktiv strukturiert, d.h., aus dem vollen können einzelne Bereiche gezielt abgetragen werden, um vorbestimmte Schaltstrukturen zu verwirklichen.

Dieser Lagenaufbau, bei dem auf eine isolierende Schicht eine leitfähige Schicht folgt, kann mehrfach wiederholt werden, wobei es sogar möglich ist, zwischen den einzelnen Lagen aus der Leiterplattentechnik bekannte, sogenannte Vias, zu erzeugen.

Je nach Material der einzelnen Schichten, den konstruktiven und ausrüstungstechnischen Besonderheiten bei der Herstellung der Strukturen können im Stand der Technik an sich bekannte Ätzverfahren, Laserabtragverfahren, Elektronenstrahlabtragungsverfahren, etc., verwendet werden.

Auch dünne Strukturen können durch Aufgalvanisieren in der Dicke verstärkt werden.

Je nach verwendeter Abtragungstechnik kann eine sehr hohe räumliche Auflösung dieser Strukturen erreicht werden. Mit Ätzverfahren vom Stand der Technik können daher Strukturen von etwa 100µm Breite hergestellt werden. Damit kann die Schaltungsdichte gegenüber dem Stand der Technik, wie er in der EP 823 832 offenbart ist, auf ein Vielfaches erhöht werden.

Auch dicke Strukturen von mehreren mm Stärke sind herstellbar. Werden diese als Spule strukturiert, sind Anwendungsfälle wie beispielsweise Induktionsbremsen kostengünstig realisierbar. Hierbei kommt neben der exzellenten mechanischen Befestigung dieser Spulenstrukturen die sehr gute thermische Kopplung mit dem Aufbauträger, auf den die Strukturen durch thermisches Spritzen aufgetragen sind, zur Wirkung.

Das im Anspruch 1 beschriebene Verfahren kann je nach angestrebter Gesamt-Schaltungsstruktur schrittweise derart wiederholt werden, daß ein mehrlagiger Schichtaufbau entsteht, wobei sich vorzugsweise leitende und nicht leitende Schichten abwechseln. Damit kann ein aus mehreren Lagen bestehender Aufbauträger realisiert werden, der bei Bedarf beispielsweise gleich integraler Bestandteil eines Gehäuses sein kann.

Der Trägerkörper kann gegebenenfalls Durchgangsöffnungen in die Substratschicht für eine oder mehrere nachfolgenden Schichten besitzen, die beispielsweise Erdungszwecken der Schaltung dienen können.

Gemäß einem zweiten, wesentlichen Aspekt der vorliegenden Erfindung kann die oben genannte Aufgabe auch dadurch gelöst werden, daß zur Erstellung einer Schaltung mit einem Dickschichtpastensystem zunächst eine elektrische Isolierschicht als Basisschicht im obigen Sinne auf einen Schaltungsträgerkörper thermisch aufgespritzt wird, wobei die Basisschicht ebenfalls die oben genannten physikalischen Eigenschaften aufweist. Dann kann eine Dickschichtpastenstruktur auf die Isolierschicht aufgebracht werden.

Derartige Aufbauten sind geeignet für einen rauhen Einsatz mit relativ großen Temperatursprüngen, vielen Temperatur- und Betriebszyklen, wie es beispielsweise in der Automobilbranche vielfach erforderlich ist. Dabei ergeben sich gegenüber in Klebetechnik realisierten Laminatverfahren vom Stand der Technik wesentlich verbesserte mechanische und thermische Eigenschaften.

Damit lassen sich die Vorteile der Dickschichtpasten-Technologie, nämlich beispielsweise das Erzielen einer hohen, räumlichen Auflösung von Schaltstrukturen, mit denen des thermischen Spritzens im allgemeinen Sinne, wie es oben beschrieben wurde, verbinden. Für die grundsätzlichen Vorteile dieses erfinderischen Verfahrens wird daher nach oben verwiesen.

Insbesondere fallen arbeits-intensive Montagearbeitsschritte weg, die isolierende Basisschicht extern herzustellen und separat mit einem Einbauteil, z.B. einem Gehäuse zu verbinden, durch Kleben, Klammern, Klemmen, Schrauben, Stecken, Nieten, Rasten, etc. Dies spart Kosten und Einbauplatz und erhöht die Betriebssicherheit, da mechanische Vibrationen keine Befestigung zerstören können.

Beispielsweise kann eine elektrisch nicht-leitende, anorganische Schicht, beispielsweise Al₂O₃ durch thermisches Spritzen auf einen metallischen Trägerkörper aufgebracht werden. Diese Nichtleiterschicht dient dann als Träger für das nachfolgende Dickschichtpastensystem. Die Herstellung des Dickschichtpastensystems kann seinerseits wie im Stand der Technik bekannt, beispielsweise wie bei sogenannten AL₂O₃-Hybridkeramiken hergestellt werden. Damit können beispielsweise Schaltungen hergestellt werden, die abgleichbare Widerstände, Induktivitäten und Kapazitäten besitzen.

Gegenüber der eingangs genannten EP 0823832 ergibt sich ebenso der Vorteil, daß eine höhere räumliche Auflösung der Schaltstruktur erreicht werden kann.

Ein weiterer Vorteil der erfinderischen Verfahrensvarianten besteht darin, daß sie dafür tauglich sind, um in Großserien fein strukturierte Schaltungen auf Trägerrohlingen wirtschaftlich zu erzeugen, die um vieles größer sind als die, wie sie in der EP 0823 832 verwendet werden. Mit den erfinderischen Verfahren können Rohlinge, die nicht eben sein müssen (3D-Strukturen ) beispielsweise als Bahnen mit mehreren Metern Länge und einer Breite von etwa 0,2 bis 0,5 Metern, je nach Herstellungsapparatur als Träger der Elektronik, und /oder Elektrik, und /oder der Mechatronik dienen.

Gemäß einem bevorzugten Ausführungsbeispiel kann die Basisschicht eine Isolierschicht sein, die lokal unterschiedlich dick aufgespritzt wird. Damit lassen sich lokale, hochspannungsfeste Isolierbereiche realisieren. Soll gleichzeitig eine sehr gute thermische Leitfähigkeit zur Abfuhr von Verlustwärme erreicht werden, so können elektrisch gut isolierende Materialien mit einer Schichtdicke von weniger als 50 Mikrometern aufgespritzt werden.

Prinzipiell können die Schichten in Luft, oder einer inerten Atmosphäre, oder bei Bedarf im Vakuum aufgespritzt werden. Unter Vakuumbedingungen lassen sich ungewollte Oxidbildungen und damit sehr genau vorhersagbare elektrische Leiteigenschaften zwischen einzelnen Schichten beziehungsweise dem Trägerkörper herstellen.

Des weiteren können auf eine thermisch gespritzte, elektrisch isolierende Basisschicht in bevorzugter Weise elektrische oder elektronische oder mechanische Bauelemente direkt auf vorbestimmte Stellen aufgebracht werden, wobei die Kontaktierungen von elektrischen oder elektronischen Bauteilen gezielt - beispielsweise durch entsprechende Lötverbindungen - zu einem definierten Potential hergestellt werden können. Die Bauelemente können beispielsweise durch eine elektrisch leitende Struktur verknüpft werden, die durch ein subtraktives Abtragen - wie oben beschrieben - aus einer aufgespritzten, leitenden Schicht erzeugt wird.

Somit lassen sich komplexe elektrische und/oder elektronische Schaltungen realisieren.

Gegenüber den AL₂O₃ Hybridkeramiken vom Stand der Technik ergibt sich der Vorteil, daß der Herstellungsprozeß vereinfacht wird, denn es ist nicht notwendig, eine vorgefertigte Keramikplatte als isolierende Basisschicht separat in den Fertigungsprozeß einzubinden.

Ein für beide vorgenannten Verfahrensvarianten gemeinsamer Vorteil gegenüber der EP 0 823 832 besteht darin, daß die elektrische Schaltung auch auf nicht-ebenen Trägerkörpern aufgebracht werden kann. Damit ergeben sich klare Bauraumeinsparungen, eine mögliche Integration des Schaltungsträgers als Gehäusewand irgendeines Aggregats oder eines Motorenteils unter Wegfall gegebenenfalls langer Zuleitungskabel zur Regelung/ Steuerung. Wenn eine erfinderisch hergestellte Schaltung einen autonomen Regelkreis beinhaltet, muß nur noch die Spannungsversorgung sowie die Verbindungen zu Aktuator und Sensor separat hergestellt werden, sofern dies nicht sogar durch Integration eines Sensors oder Aktuators auf dem Schaltungsträger selbst möglich ist. Auch das Anfertigen einer Schaltung auf einem flexibel ausgebildeten Träger ist möglich.

Die erfinderischen Verfahren gemäß dem ersten wesentlichen Aspekt und dem zweiten wesentlichen Aspekt erlauben eine feinere Schaltungsstruktur und gleichzeitig die Möglichkeit, auch im grobskaligen Bereich elektrische Strukturen billig herzustellen. So können beispielsweise Linearmotoren günstig hergestellt und in das zugehörige Bauteil integriert werden. Ein solcher Aufbau kann dann beispielsweise als großdimensionierte Induktionsbremse für Fahrzeuge dienen. Die nach den erfinderischen Verfahren hergestellten Schaltungen können außerdem samt Schaltungsträger als redundante Steuer- oder Regelkreise in Aggregate mit erhöhten Sicherheitsanforderungen eingebunden werden. So kann beispielsweise ein Düsentriebwerk eines Flugzeugs mit einem automatischen Regelkreis versehen werden, der aktiviert wird, wenn die elektrischen Zuleitungen, die im Stand der Technik für das Triebwerk vorhanden sind, durch einen Notfall bedingt ausfallen sollten. Dies ist nur dadurch möglich, daß der Regelkreis in unmittelbarer Nähe des zu regelnden Aggregats angebracht werden und autonom gegebenenfalls mit eigener Stromversorgung arbeiten kann.

Gemäß einem dritten, wesentlichen Aspekt der vorliegenden Erfindung wird ein Verfahren zur Herstellung einer elektrischen Schaltung auf einem Trägerkörper vorgesehen, bei dem die Basisschicht im wesentlichen als Träger für vorgefertigte Bauelemente dient. Es enthält dann im wesentlichen die folgenden Schritte:
a) Thermisches Spritzen der isolierenden Basisschicht mit gemäß der Schaltung vorbestimmten, physikalischen Eigenschaften auf den Trägerkörper,
b) Aufbringen einer oder mehrerer elektrischer, elektronischer oder mechanischer Bauelemente auf vorbestimmte Bereiche der Isolierschicht, sowie
c) Verknüpfen der Bauelemente gemäß der vorbestimmten Schaltungsfunktion.

Schritt a) kann dabei wie oben beschrieben durchgeführt werden. In Schritt b) können die verschiedenartigen Bauelemente je nach ihrer Natur, Struktur und Funktion auf vorbestimmte Kontaktierungsstellen aufgebracht, oder lediglich fest mit der Basisschicht verbunden, beispielsweise geklebt werden, und dann unabhängig von dieser Befestigung miteinander gemäß der zu erzielenden Funktion verknüpft werden. Lötverbindungen, Kabelverbindungen und mechanische Verbindungen können hierbei je nach Bedarf eingesetzt werden. Eine Passivierungsschicht kann hinzugefügt werden, um die Bauelemente zu ummanteln und zusätzlich die Gesamtschaltung an der gespritzten Basisschicht zu befestigen.

Der Vorteil gegenüber dem Stand der Technik, wie er oben diskutiert ist, besteht darin, dass Schaltungen insbesondere in solchen Anwendungsfällen einfacher hergestellt werden können, in denen die Schaltung durch Fertigbausteine allein realisiert werden kann.

Ein wesentlicher Vorteil besteht aber auch darin, dass damit auch auf fast beliebig dreidimensional geformten, und sogar flexiblen Trägern eine Schaltung direkt erzeugt werden kann. Je nach Einzelfall der Anwendung kann dabei Platz und Befestigungsaufwand für eine separate Platine eingespart werden, die sonst in solchen Fällen als Schaltungsträger dient.

### ZEICHNUNGEN

Ausführungsbeispiele der Erfindung sind in den Zeichnungen dargestellt und in der nachfolgenden Beschreibung näher erläutert.

Es zeigen:
- Fig. 1: einen schematischen Querschnitt durch einen gemäß dem ersten Aspekt des erfinderischen Verfahrens hergestellten Schichtaufbau;
- Fig. 2: ein Ablaufdiagramm in Übersichtsform mit den Verfahrensschritten, die für den Schichtaufbau aus Fig. 1 notwendig sind;

### BESCHREIBUNG DER AUSFÜHRUNGSBEISPIELE

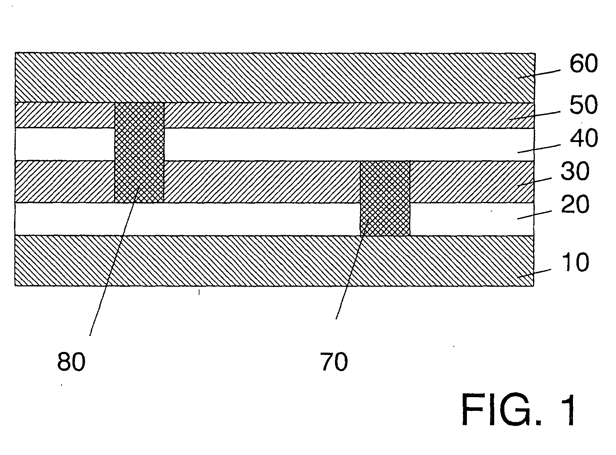

Mit allgemeinen Bezug zu den Zeichnungen und besonderem Bezug zu **Fig. 1** soll durch das erfinderische Verfahren gemäß einem bevorzugten Ausführungsbeispiel ein Schichtaufbau hergestellt werden, wie er in Fig. 1 schematisch dargestellt ist.

Dieser Schichtaufbau enthält im ganzen sechs Schichten, die parallel übereinander liegen. Diese Schichten sind in Fig. 1 waagerecht gezeichnet. Zwei vertikale, schichtverbindende Strukturen, sogenannte Vias 70, 80 sind ebenfalls vorgesehen. Im einzelnen ist die unterste Schicht 10 die Substratschicht. Die Substratschicht besteht im vorliegenden Fall aus einem Blech mit einer Dicke von 2 mm. Dabei sei angemerkt, daß der Schichtaufbau nur schematisch gezeichnet ist, daß heißt, die gezeichneten Dikken der einzelnen Schichten entsprechen nicht der wirklichen Dickenrelation der Schichten zueinander.

Über der Substratschicht befindet sich eine elektrisch isolierende Aluminiumoxidschicht 20. Darüber befindet sich eine Kupferschicht 30. Über der Kupferschicht 30 befindet sich nochmals eine elektrisch isolierende Aluminiumoxidschicht 40. Über dieser Oxidschicht befindet sich wiederum eine elektrisch leitende Schicht 50, ebenfalls aus Kupfer, und eine Passivierungsschicht 60 aus elektrisch nicht leitendem Material ist als äußerste Schicht vorgesehen.

Ein vertikal gezeichneter Übergang 70, der sogenannte Via, verbindet die leitende Schicht 30 mit dem Substrat 10 für Erdungszwecke der Schaltung. Ein zweiter Via 80 verbindet die leitende Schicht 50 mit der leitenden Schicht 30. Auf weitere Einzelheiten der Schaltung selbst braucht für die Zwecke der vorliegenden Erfindung zunächst nicht näher eingegangen werden.

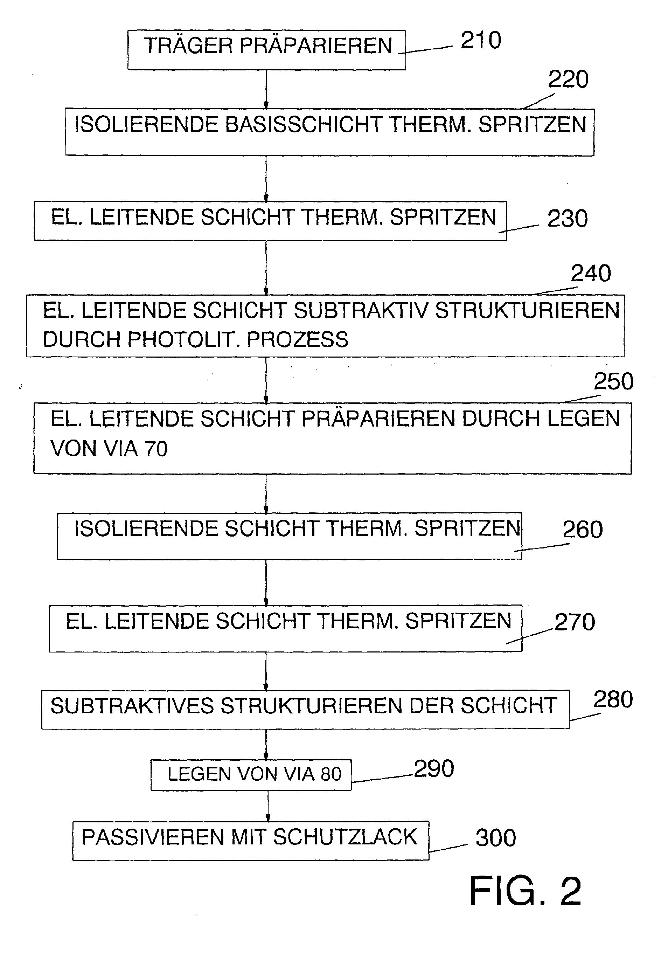

Mit Bezug zu **Fig. 2** wird nun das erfindungsgemäße Verfahren gemäß einem bevorzugten Ausführungsbeispiel und seinem ersten wesentlichen Aspekt genauer beschrieben:

In einem ersten Schritt 210 wird das Substrat 10 für den folgenden Schichtaufbau präpariert. Insbesondere wird die Substratoberfläche gereinigt, und von eventuell vorhandenen Oxidresten befreit, wie es im Stand der Technik bekannt ist.

Danach wird in einem Schritt 220 großflächig eine isolierende Basisschicht 20 durch thermisches Spritzen auf das Substrat aufgebracht. Als Material hierfür wird Aluminiumoxid (AL₂O₃) verwendet. Die Schichtdicke kann dabei zwischen etwa einem Mikrometer und mehreren Millimetern variiert werden, je nachdem, welche elektrischen oder thermischen Eigenschaften erreicht werden sollen.

Das Material der Basisschicht soll dabei bestimmten physikalischen Eigenschaften genügen, die zum Betrieb der Schaltung im späteren Anwendungsfall erforderlich beziehungsweise für eine Optimierung deren Betriebs dienen. Das Material kann beispielsweise eine gute thermische Leitfähigkeit besitzen oder, alternativ, eine bewußt gewählte niedrige thermische Leitfähigkeit, je nachdem ob der Trägerkörper im Normalbetrieb einen Wärmestrom zur Schaltung hin oder von ihr weg verursacht. Es sollte jedenfalls gewährleistet sein, daß die von der Schaltung erzeugte Verlustwärme möglichst von der Schaltung abgeführt werden kann, was meist durch die erste Basisschicht hindurch erfolgt. Wenn eine thermische Isolierung angestrebt wird, kann beispielsweise Zirkonoxid verwendet werden. Soll statt dessen ein guter Wärmedurchgang erreicht werden, kann beispielsweise Borsilicat, Aluminiumoxid oder Aluminiumnitrid verwendet werden.

Da die Basisschicht auf das Substrat aufgespritzt wird, muß sie nicht während des Herstellungsverfahrens separat vom Trägerkörper transportiert oder bearbeitet werden.

Danach wird eine elektrisch leitende Schicht 30 durch thermisches Spritzen auf die isolierende Basisschicht 20 in einem Schritt 230 aufgebracht. Als Material wird Kupfer (CU) verwendet. Die Kupferschicht 30 wird in einer Dicke von etwa 100 Mikrometern aufgetragen.

Danach wird in einem photolithographischen Prozeß die Kupferschicht 30 subtraktiv strukturiert. Die Kupferschicht wird dazu mit lichtempfindlichem Lack (Photolack) überzogen und durch eine Photoschablone hindurch belichtet und entwickelt. Danach kann die Metallisierung durch die vom Photolack frei gelegten Stellen geätzt werden.

Die Photoschablone enthält dann die gewünschte elektrische Struktur, die auf der leitenden Schicht 30 realisiert werden soll. Erfindungsgemäß werden hier die Schablonen oder Masken nicht zum Hindurchspritzen verwendet, wie es im Stand der Technik angegeben wurde, sondern nur, um Licht durch die Maskenöffnungen zu schicken. Somit unterbleibt eine Verschmutzung der Masken, was dazu führt, daß diese ohne Probleme wiederverwendet werden können.

Danach wird in einem Schritt 250 der Via 70 als elektrisch leitende Verbindung, beziehungsweise Verbindungskanal zwischen leitender Kupferschicht 30 und elektrisch leitendem Substrat 10 angefertigt: auch hierfür können Techniken vom Stand der Technik verwendet werden. Solche in die Tiefe gehenden Kanäle 70, 80 können beispielsweise durch Ätztechniken mit einem Durchmesser von 0,5 mm bis 1 mm hergestellt werden.

Danach wird das geätzte Loch mit einem Leitkleber verfüllt. Als Leitkleber kommt beispielsweise Kupferpaste in Frage.

Danach wird in einem Schritt 260 eine weitere, isolierende Schicht, nämlich Schicht 40 thermisch aufgespritzt. Auch hierfür wird wieder Aluminiumoxid verwendet.

Danach wird in einem weiteren Arbeitsschritt 270 eine zweite leitende Schicht, ebenfalls eine Kupferschicht 50, auf die Schicht 40 aufgebracht. Alle technischen Einzelheiten können wie oben beschrieben auch hierfür Anwendung finden.

Danach wird analog zu Schritt 240 die Kupferschicht 50 erneut subtraktiv strukturiert, Schritt 280, was ebenso wie oben beschrieben mit Hilfe eines photolithographischen Prozesses durchgeführt wird.

Danach wird, ebenfalls analog zu Schritt 250 ein Via als Verbindung von Kupferschicht 50 zu Kupferschicht 30 gelegt, Schritt 290, indem ein dünner Kanal durch Schicht 50, Schicht 40 und Schicht 30 geätzt wird. Das entstandene, geätzte Loch wird danach ebenfalls mit Leitpaste als Leitkleber verfüllt.

Falls erforderlich, können in die Schicht 50 noch ergänzend und in Abweichung zu Fig. 1 weitere Schichten aufgebracht werden, oder fertige elektrische und/oder elektronische Bauelemente an vorbestimmten Stellen auf der Schicht 50 angebracht werden, wobei diese an vorbestimmten Stellen kontaktiert werden, wie es im Stand der Technik üblich ist.

Danach wird in einem Schritt 300 der somit hergestellte Schichtaufbau, der die elektrische/elektronische Schaltung enthält, passiviert, indem ein Schutzlack mit entsprechender Dicke, beispielsweise 25µm aufgetragen wird.

Gemäß dem zweiten grundlegenden Aspekt der vorliegenden Erfindung kann auch ein sogenanntes Dickschichtpastensystem auf die erfinderische, thermisch aufgespritzte Isolierschicht in vorteilhafter Weise aufgetragen werden. Dafür wird der Träger analog zu oben zunächst präpariert und danach die isolierende Basisschicht thermisch aufgespritzt. Diese thermisch aufgespritzte Schicht kann nun als eigentlicher Träger für das Dickschichtpastensystem verwendet werden. Das Dickschichtpastensystem selbst kann in an sich bekannter Art und Weise aufgebaut werden, wie es beispielsweise bei den sogenannten Aluminiumoxid-Hybridkeramiken der Fall ist. Erfindungsgemäß wird es jedoch auf die thermisch aufgespritzte Schicht aufgebracht. Es können z.B. die in der Hybridtechnik üblichen Ag-, Cu, Carbon- oder auch andere Widerstandspasten aufgetragen werden.

Somit können auch Widerstände, insbesondere abgleichbare Widerstände oder Induktivitäten oder Kapazitäten realisiert werden. Des weiteren kann die durch thermisches Spritzen aufgebrachte elektrisch isolierende Basisschicht je nach Vorgaben lokal unterschiedlich dick sein, um beispielsweise an bestimmten Stellen besonders hochspannungsfest zu sein.

Als Mittelwert für eine nicht besonders ausgelegte Hochspannungsfestigkeit kann bei Aluminiumoxid (AL₂O₃) als Orientierungswert eine Schichtdicke von etwa 100 Mikrometern als ausreichend für normale elektrische Isolierung herangezogen werden.

Als klarer Vorteil dieser zweiten Ausgestaltung des erfinderischen Verfahrens läßt sich festhalten, daß erfindungsgemäß ein Dickschichtpastensystem derart mit einem Träger verbindbar ist, daß ein besonderer Arbeitsschritt des Befestigens des Dickschichtpastensystems an dem Träger wegfällt.

Obwohl die vorliegende Erfindung anhand eines bevorzugten Ausführungsbeispiels vorstehend beschrieben wurde, ist sie darauf nicht beschränkt, sondern auf vielfältige Weise modifizierbar.

Alle spritzbaren Materialien sind prinzipiell verwendbar. Grundsätzlich sind teigige Zustände, das heißt zwischen festem und flüssigen Aggregatzustand befindliche Zustände in der Kammer zu bevorzugen. Gespritzt wird mit vorzugsweise hoher Geschwindigkeit, z.B. 1200 bis 2100 m/s - Überschall - nach Techniken des Standes der Technik. Vermieden werden soll beim Thermischen Spritzen für die hier vorliegenden Zwecke ein ungewolltes Verlaufen des Spritzguts nach Aufbringen auf dem Substrat, damit eine gleichmäßige, möglichst homogene Schicht realisiert werden kann.

Die zu wählenden Flammtemperaturen beim thermischen Spritzen sind dann abhängig vom Schmelz- und Siedepunkt des Spritzmaterials und liegen im allgemeinen zwischen diesen, jedenfalls oberhalb dessen Schmelzpunktes. Sie sind weiter abhängig von der Größe der Partikel. Metalle wie Kupfer, Aluminium, oder andere anorganische Materialien wie Aluminiumoxid, Borsilikat können verwendet werden, die dann die beabsichtigten Eigenschaften beispielsweise bezüglich thermischer oder elektrischer Leitfähigkeit besitzen.

Das Verfahren kann auch kombiniert werden mit anderen additiven Verfahren, beispielsweise so, dass es einen Arbeitsschritt enthält, bei dem auf einen metallischen Träger eine Aluminiumoxidschicht bestimmter Dicke, z.B. von 10 Mikrometer, thermisch im Vakuum aufgepritzt wird, und einen weiteren Schritt mit galvanischem Aufkupfern einer flächigen Schicht mit nachfolgenden Ätz-Abtragen von Material, so dass die angestrebte Struktur in der zweiten Schicht realisiert wird, wie es bei der Leiterplattenherstellung getan wird. Damit können sehr gute mechanische sowie thermische Verbundeigenschaften zwischen elektrisch leitfähiger und isolierender Schicht realisiert werden.

Schließlich können die Verfahren gemäß den geschilderten drei verschiedenen Aspekten auch räumlich neben- oder übereinander kombiniert werden, um den Schaltungsaufbau an einen bestimmten Einsatzort, ein bestimmtes, anzusteuerndes Aggregat, oder verschiedene Betriebsbedingungen der Schaltung, insbesondere Temperaturverhältnisse, anzupassen. Eine Schicht aus Fertigbauelementen sollte dabei vorzugsweise zum Schluß aufgebracht werden, wenn die Kombination räumlich übereinander erfolgt.

## Patentansprüche

1. Verfahren zur Herstellung einer elektrischen Schaltung auf einem Trägerkörper (10), enthaltend die Schritte thermisches Spritzen (220) einer ersten Basisschicht (20) mit gemäß der Schaltung vorbestimmten, physikalischen Eigenschaften auf den Trägerkörper,
Aufbringen (230) einer zweiten Schicht (30) auf die Basisschicht, **gekennzeichnet durch** den Schritt :
subtraktives Strukturieren der zweiten Schicht gemäß vorbestimmter Schaltstrukturen.

2. Verfahren nach Anspruch 1, wobei der Schritt des Aufbringens (230) der zweiten Schicht (30) durch thermisches Spritzen erfolgt.

3. Verfahren nach Anspruch 1, wobei das Aufbringen (230) durch Galvanisieren erfolgt.

4. Verfahren zur Herstellung einer ein Dickschichtpastensystem enthaltenden Schaltung auf einem Trägerkörper, **gekennzeichnet durch** die Schritte:
thermisches Spritzen wenigstens einer elektrischen Isolierschicht als Basisschicht mit gemäß der Schaltung vorbestimmten, physikalischen Eigenschaften auf den Trägerkörper,
Aufbringen und Einbrennen einer Struktur aus Dickschichtpaste, wobei die Isolierschicht und der Träger aus einem Material bestehen, das einen höheren Schmelzpunkt besitzt als die Einbrenntemperatur der Dickschichtpaste.

5. Verfahren nach Anspruch 1, 2 oder 4, wobei die Basisschicht (20) eine thermisch gespritzte (220) Isolierschicht aus anorganischem Material, bevorzugt einem Aluminiumoxid, ist.

6. Verfahren nach einem der vorstehenden Ansprüche, wobei eine Isolierschicht mit unterschiedlichen Dicken an vorbestimmten Stellen des Schaltungsaufbaus erzeugt wird.

7. Verfahren nach einem der vorstehenden Ansprüche, bei dem wenigstens eine Schicht im Vakuum aufgespritzt wird.

8. Verfahren nach einem der vorstehenden Ansprüche, enthaltend die Schritte,
Aufbringen einer oder mehrerer weiterer Schichten auf die sich jeweils ergebende Schichtstruktur, wobei jeweilige Schichtmaterialien vorbestimmte, elektrische oder elektronische Eigenschaften besitzen,
Legen (250, 290) von Vias (70, 80) zum Kontaktieren einer darüber aufzubringenden Schicht.

9. Verfahren nach Anspruch 8, weiter enthaltend den Schritt,
Aufbringen einer oder mehrerer elektrischer, elektronischer oder mechanischer Bauelemente auf vorbestimmte Bereiche einer Isolierschicht (20, 40),
Verknüpfen der Bauelemente gemäß einer vorbestimmten Schaltungsfunktion.

10. Verfahren nach einem der vorstehenden Ansprüche, enthaltend die Schritte
wenigstens eine elektrisch gut leitende Schicht (30, 50) durch thermisches Spritzen (230, 270) auf die auf dem Schaltungsträger (10) vorhandene Schichtstruktur aufzubringen,
Abtragen (240, 280) der Schicht gemäß vorbestimmter Schaltstrukturen, um elektrische Bauelemente zu erzeugen.

11. Verfahren nach einem der vorstehenden Ansprüche, bei dem der Schritt des Abtragens einer oder mehrerer Schichten (20, 40) durch Ätzen, Laser-, oder Elektronenstrahlabtragung erfolgt.

12. Verfahren zur Herstellung einer elektrischen Schaltung auf einem Trägerkörper (10), enthaltend die Schritte thermisches Spritzen (220) einer ersten isolierenden Basisschicht (20) mit gemäß der Schaltung vorbestimmten, physikalischen Eigenschaften auf den Trägerkörper, Aufbringen einer oder mehrerer elektrischer, elektronischer oder mechanischer Bauelemente auf vorbestimmte Bereiche der Isolierschicht (20),
Verknüpfen der Bauelemente gemäß einer vorbestimmten Schaltungsfunktion.

13. Trägerkörper (10), enthaltend eine elektrische Schaltung, die nach einem oder mehreren Verfahren gemäß einem der vorstehenden Ansprüche hergestellt ist.

14. Verwendung eines Trägerkörpers (10) mit einer Schaltung gemäß vorstehendem Anspruch als Teil eines Gehäuses, als Teil einer Maschine, oder eines Generators, oder eines Elektromotors, oder eines Linearmotors zur Steuerung oder Regelung des- oder derselben.

15. Elektrische Schaltung, die nach einem oder mehreren Verfahren gemäß einem der vorstehenden Ansprüche 1 bis 12 hergestellt ist.
